# EUROPEAN PATENT APPLICATION

(11) **EP 3 550 722 A1**
(43) Date of publication of application: **09.10.2019**
(21) Application number: 16924398.7
(22) Date of filing: 23.12.2016
(51) Int. Cl.: H03H 9/64

(54) **FILTER AND METHOD FOR ADJUSTING PERFORMANCE OF FILTER**

(71) Applicant: Huawei Technologies Co., Ltd., Longgang Shenzhen, Guangdong 518129 (CN)
(72) Inventor: GU, Jian, Shenzhen Guangdong 518129 (CN); NURMELA, Arto Turo Ilmari, Shenzhen Guangdong 518129 (CN); ZHANG, Le, Shenzhen Guangdong 518129 (CN)
(74) Representative: Gill Jennings & Every LLP
(86) International application number: PCT/CN2016/111813
(87) International publication number: WO 2018/112921

(57) **Abstract**

Embodiments of this application provide a filter and a method for adjusting performance of a filter, so as to quickly adjust performance of a filter. The filter includes at least two acoustic wave resonators; and a performance adjustment structure, connected to an output end of a first acoustic wave resonator and an input end of a second acoustic wave resonator, where the first acoustic wave resonator and the second acoustic wave resonator are any two of the at least two acoustic wave resonators, the performance adjustment structure includes a capacitor structure and/or an inductor structure, and the performance adjustment structure is configured to adjust an energy coupling mode between the first acoustic wave resonator and the second acoustic wave resonator.

## Description

### TECHNICAL FIELD

This application relates to the communications field, and more specifically, to a filter and a method for adjusting performance of a filter.

### BACKGROUND

A filter is an important radio frequency device that ensures performance of a wireless communications product. Currently, a demand for miniaturization of the wireless communications product is becoming increasingly strong, and therefore there is an increasingly high requirement for a size of a filter in the wireless communications product. Sizes of a metal cavity filter and a dielectric filter based on an electromagnetic wave principle can hardly be greatly reduced, and therefore another form of filter is required to meet a demand for miniaturization of a radio frequency front-end. Compared with a conventional filter in an electromagnetic wave resonance mode, sizes of a bulk acoustic wave (full name: Bulk Acoustic Wave, BAW for short) filter and a surface acoustic wave (full name: Surface Acoustic Wave, SAW for short) filter in an acoustic wave resonance mode are remarkably reduced. Therefore, the bulk acoustic wave filter and the surface acoustic wave filter are widely applied to various small-size wireless communications products. Based on different acoustic wave reflecting layers, bulk acoustic wave (BAW) filters are divided into two technical branches: film bulk acoustic resonator (Film Bulk Acoustic resonator, FBAR for short) filters and solidly mounted resonator (full name: Solidly Mounted Resonators, SMR for short) filters. An acoustic wave reflection structure of a resonator of an FBAR filter is implemented by using an air cavity, while an acoustic wave reflection structure of a resonator of an SMR filter is implemented by using a Bragg (Bragg) reflecting layer composed of high and low acoustic impedance layers.

Out-of-band rejection and passband performance are important indicators for evaluating radio frequency performance of acoustic wave filters (including a BAW filter and an SAW filter). The out-of-band rejection indicator reflects a capability of a filter in suppressing an out-of-passband interference signal, while passband characteristics including an insertion loss, a return loss, and the like reflect a capability of the filter in selecting frequency of a usable signal in a specified passband. Out-of-band rejection and passband performance of an acoustic wave filter are usually determined by several aspects such as a resonator shape, a connection form between resonators, and a topological structure of the filter.

It is very difficult to adjust a resonator shape and a connection relationship between resonators because an acoustic wave filter is fabricated depending on a complex semiconductor technology. Therefore, it is very difficult to implement quick adjustment of performance of the acoustic wave filter.

### SUMMARY

Embodiments of this application provide a filter and a method for adjusting performance of a filter, so as to quickly adjust performance of a filter.

According to a first aspect, a filter is provided, including at least two acoustic wave resonators; and a performance adjustment structure, connected to an output end of a first acoustic wave resonator and an input end of a second acoustic wave resonator, where the first acoustic wave resonator and the second acoustic wave resonator are any two of the at least two acoustic wave resonators, the performance adjustment structure includes a capacitor structure and/or an inductor structure, and the performance adjustment structure is configured to adjust an energy coupling mode between the first acoustic wave resonator and the second acoustic wave resonator, so as to implement adjustment of performance of the filter. Optionally, the performance adjustment structure may be a capacitor structure, an inductor structure, or a combined structure of a capacitor and an inductor.

That the performance adjustment structure is connected between any two acoustic wave resonators of the filter is equivalent to that an energy coupling path is added between the two acoustic wave resonators, that is, an energy coupling mode between the two acoustic wave resonators is changed. The energy coupling mode may include a coupling type and coupling strength, and the coupling type may include inductive coupling and capacitive coupling. When the performance adjustment structure is an inductor structure, it can be understood as that inductive coupling is added between the two acoustic wave resonators, and coupling strength is related to an inductance value of the inductor structure. When the performance adjustment structure is a capacitor structure, it can be understood as that capacitive coupling is added between the two acoustic wave resonators, and coupling strength is related to a capacitance value of the capacitor structure. Different energy coupling modes are corresponding to different filter performance. Therefore, performance of the filter can be quickly adjusted by adjusting the performance adjustment structure.

Optionally, the first acoustic wave resonator and the second acoustic wave resonator are non-adjacent resonators.

That the first acoustic wave resonator and the second acoustic wave resonator are non-adjacent resonators is equivalent to that a cross-coupling mode similar to a cross-coupling mode of a filter operating based on an electromagnetic wave principle is added. Therefore, a coupling matrix of the filter is changed, and further the performance of the filter is changed.

Optionally, the performance adjustment structure is implemented in at least one of the following manners: a bonding wire, a metal via, an embedded metal wire, a discrete inductor device, or a discrete capacitor device.

Optionally, the bonding wire may be a gold bonding wire, and the embedded metal wire may be a spiral embedded wire.

Optionally, the performance adjustment structure is connected between the output end of the first acoustic wave resonator and the input end of the second acoustic wave resonator through welding or embedding.

Optionally, the acoustic wave resonator in the filter may be a bulk acoustic wave resonator or a surface acoustic wave resonator. For example, the first acoustic wave resonator and the second acoustic wave resonator may be bulk acoustic wave resonators or surface acoustic wave resonators.

According to a second aspect, a method for adjusting performance of a filter is provided, including: connecting a performance adjustment structure between an output end of a first acoustic wave resonator and an input end of a second acoustic wave resonator, where the performance adjustment structure includes a capacitor structure and/or an inductor structure, the filter includes at least two acoustic wave resonators, and the first acoustic wave resonator and the second acoustic wave resonator are any two of the at least two acoustic wave resonators; and adjusting an energy coupling mode between the first acoustic wave resonator and the second acoustic wave resonator by using the performance adjustment structure.

In a possible implementation, the first acoustic wave resonator and the second acoustic wave resonator are non-adjacent resonators.

In a possible implementation, the performance adjustment structure is implemented in at least one of the following manners: a bonding wire, a metal via, an embedded metal wire, a discrete inductor device, or a discrete capacitor device.

In a possible implementation, the connecting a performance adjustment structure between an output end of a first acoustic wave resonator and an input end of a second acoustic wave resonator includes:
connecting the performance adjustment structure between the output end of the first acoustic wave resonator and the input end of the second acoustic wave resonator through welding or embedding.

Optionally, the at least two acoustic wave resonators may be bulk acoustic wave resonators or surface acoustic wave resonators. For example, the first acoustic wave resonator and the second acoustic wave resonator may be bulk acoustic wave resonators or surface acoustic wave resonators.

According to a third aspect, this application further provides a communications device, where the communications device includes the filter according to any implementation of the first aspect. Optionally, the communications device may be a network device in a wireless communications network, such as a base station or a wireless transceiver apparatus, or may be a terminal device such as a mobile phone.

Therefore, according to the filter in the embodiments of this application, the performance adjustment structure is connected between any two acoustic wave resonators of the filter, and the performance adjustment structure includes a capacitor structure and/or an inductor structure. In this way, performance of the filter can be quickly adjusted by adjusting a capacitance or inductance parameter value of the performance adjustment structure.

### BRIEF DESCRIPTION OF DRAWINGS

FIG. 1 is a topological structure diagram of a filter according to an embodiment of this application;
FIG. 2A is a topological structure diagram of a filter to which no performance adjustment structure is added;
FIG. 2B is a topological structure diagram of a filter to which an inductor structure is added;
FIG. 3A is a simulation diagram of passband performance of a filter when inductance is 1 nanohenry;
FIG. 3B is a simulation diagram of passband performance of a filter when inductance is 3 nanohenries;
FIG. 3C is a simulation diagram of passband performance of a filter when inductance is 7 nanohenries;
FIG. 4A is a simulation diagram of out-of-band rejection performance of a filter to which no inductor structure is added;
FIG. 4B is a simulation diagram of out-of-band rejection performance of a filter to which an inductor structure is added;
FIG. 5 is a topological structure diagram of a filter to which a combined structure of an inductor and a capacitor is added;
FIG. 6 is a simulation diagram of out-of-band rejection performance of a filter to which a combined structure of an inductor and a capacitor is added; and
FIG. 7 is a schematic flowchart of a method for adjusting performance of a filter according to an embodiment of this application.

### DESCRIPTION OF EMBODIMENTS

The following describes technical solutions in the embodiments of this application with reference to accompanying drawings in the embodiments of this application.

It should be understood that, the technical solutions of this application can be applied to various communications systems, for example, a Global System for Mobile Communications (Global System of Mobile communication, "GSM" for short) system, a Code Division Multiple Access (Code Division Multiple Access, "CDMA" for short) system, a Wideband Code Division Multiple Access (Wideband Code Division Multiple Access, "WCDMA") system, a general packet radio service (General Packet Radio Service, GPRS) system, a Long Term Evolution (Long Term Evolution, "LTE" for short) system, an advanced Long Term Evolution (Advanced long term evolution, "LTE-A" for short) system, a Universal Mobile Telecommunications System (Universal Mobile Telecommunication System, "UMTS" for short), and a fifth generation (5th Generation, "5G" for short) mobile communications system.

As described above, in an existing communications system, because most filters are fabricated depending on a complex semiconductor technology, many rounds of optimization are usually required to adjust performance of a filter by adjusting a resonator shape and a connection relationship between resonators. A resonator shape and a connection mode between resonators may need to be adjusted in each round of optimization, and consequently adjustment efficiency is very low and an optimization effect is limited. Therefore, a filter whose performance can be quickly adjusted is urgently needed.

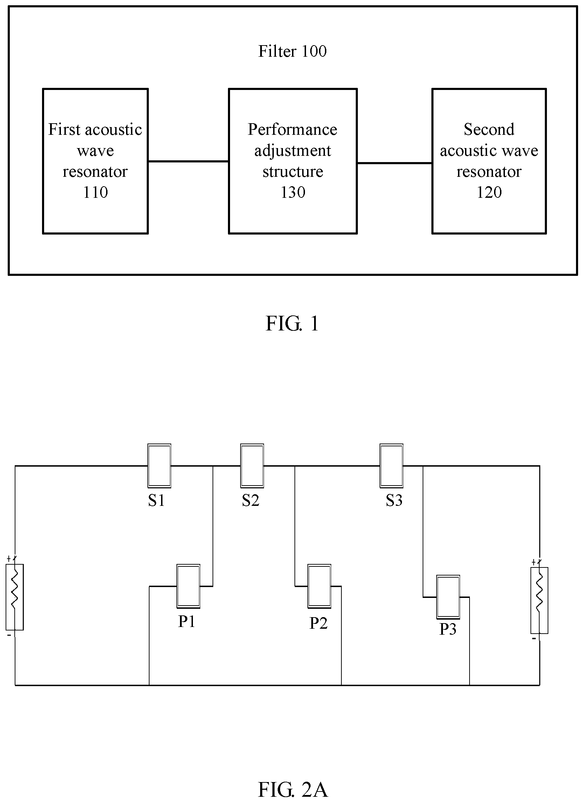

Based on this, an embodiment of this application provides a filter. FIG. 1 is a schematic structural diagram of a filter 100 according to an embodiment of this application. As shown in FIG. 1, the filter 100 includes:
at least two acoustic wave resonators, where a first acoustic wave resonator 110 and a second acoustic wave resonator 120 are any two of the at least two acoustic wave resonators; and
a performance adjustment structure 130, connected to an output end of the first acoustic wave resonator 110 and an input end of the second acoustic wave resonator 120, where the performance adjustment structure includes a capacitor structure and/or an inductor structure; and
the performance adjustment structure 130 is configured to adjust an energy coupling mode between the first acoustic wave resonator 110 and the second acoustic wave resonator 120.

Specifically, that the performance adjustment structure 130 is connected between the first acoustic wave resonator 110 and the second acoustic wave resonator 120 is equivalent to that another energy coupling path is added between the first acoustic wave resonator 110 and the second acoustic wave resonator 120, that is, an energy coupling path through which the first acoustic wave resonator 110, the performance adjustment structure 130, and the second acoustic wave resonator 120 are connected is added. From a field-like perspective, that the energy coupling path is added is equivalent to that an energy coupling mode similar to an energy coupling mode of a filter operating based on an electromagnetic wave principle is added between the first acoustic wave resonator 110 and the second acoustic wave resonator 120. Therefore, a coupling matrix of the filter is changed, and further in-passband rejection performance and out-of-passband rejection performance of the filter are changed. Alternatively, from a perspective of a circuit, in-passband performance and out-of-passband performance of the filter change with adjustment of a topological structure of the circuit. Therefore, that the performance adjustment structure 130 is connected between the first acoustic wave resonator 110 and the second acoustic wave resonator 120 is equivalent to that the energy coupling mode between the two acoustic wave resonators is changed. Different energy coupling modes between resonators are corresponding to different filter characteristics. Therefore, a characteristic of the filter can be adjusted by adjusting the performance adjustment structure. For example, when the performance adjustment structure includes an inductor structure, performance of the filter can be quickly adjusted by adjusting an inductance value. For another example, when the performance adjustment structure includes a capacitor structure, performance of the filter can be quickly adjusted by adjusting a capacitance value.

Optionally, in this embodiment of this application, the first acoustic wave resonator and the second acoustic wave resonator may be adjacent resonators or may be non-adjacent resonators.

That the first acoustic wave resonator and the second acoustic wave resonator are non-adjacent resonators is equivalent to that a cross coupling mode similar to a cross coupling mode of the filter operating based on the electromagnetic wave principle is added between the first acoustic wave resonator 110 and the second acoustic wave resonator 120. Therefore, the coupling matrix of the filter is changed, and further the in-passband rejection performance and the out-of-passband rejection performance of the filter are changed.

It should be understood that, in an actual application, it may be determined, based on a specific scenario, to add a performance adjustment structure of a specific structure; or it may be determined, based on an actual requirement, to add a performance adjustment structure between which two acoustic wave resonators; or a performance adjustment structure may be added between each two of at least two acoustic wave resonators. For example, a performance adjustment structure 1 is added between a first acoustic wave resonator and a second acoustic wave resonator, and a performance adjustment structure 2 may be added between a third acoustic wave resonator and a fourth acoustic wave resonator, where the performance adjustment structure 1 and the performance adjustment structure 2 may be the same or may be different in structure; and the performance adjustment structure 1 and the performance adjustment structure 2 may be adjusted according to an actual case.

In a specific implementation, the performance adjustment structure may be an inductor structure, where the inductor structure may be implemented in at least one of the following manners: a bonding wire, a metal via, an embedded metal wire, and a discrete inductor device. Optionally, the bonding wire may be a gold bonding wire, and the embedded metal wire may be a spiral embedded wire. Alternatively, the performance adjustment structure may be a capacitor structure, where the capacitor structure may be implemented in at least one of the following manners: a plate capacitor, a discrete capacitor device, and the like. Alternatively, the performance adjustment structure may be a combined structure of an inductor and a capacitor, where the inductor structure in the combined structure may be implemented through at least one of the foregoing implementations of the inductor structure, and the capacitor structure in the combined structure may be implemented through at least one of the foregoing implementations of the capacitor structure.

In other words, if the performance adjustment structure is an inductor structure, the performance adjustment structure may be implemented in at least one of the following manners: a bonding wire, a metal via, an embedded metal wire, and a discrete inductor device.

For example, the performance adjustment structure may be a gold bonding wire, a combination of a gold bonding wire and a metal via, a combination of a gold bonding wire, a metal via, and a discrete inductor device, or the like. If the performance adjustment structure is a capacitor structure, the performance adjustment structure may be a discrete capacitor device, a plate capacitor, a combination of a discrete capacitor device and a plate capacitor, or the like. If the performance adjustment structure is a combined structure of an inductor and a capacitor, the performance adjustment structure may be a combined structure of a gold bonding wire and a discrete capacitor device, a combination of a plate capacitor and a metal via, or the like.

Optionally, the performance adjustment structure is connected between the output end of the first acoustic wave resonator 110 and the input end of the second acoustic wave resonator 120 through welding or embedding.

For example, if the performance adjustment structure is a bonding wire, a discrete inductor device, or a discrete capacitor device, the performance adjustment structure may be connected between the output end of the first acoustic wave resonator and the input end of the second acoustic wave resonator through welding; or if the performance adjustment structure is a metal via or an embedded metal wire, the performance adjustment structure may be connected between the output end of the first acoustic wave resonator and the input end of the second acoustic wave resonator through embedding.

Optionally, the filter is a bulk acoustic wave resonator or a surface acoustic wave resonator. Resonator structures and working principles of an FBAR filter and an SMR filter are the same, and therefore the performance adjustment structure proposed in this embodiment of this application is applicable to the FBAR filter and the SMR filter. Based on a structure and a principle that are similar to or the same as the foregoing structures and principles, this embodiment of this application is also applicable to a surface acoustic wave resonator. Optionally, if the filter is a bulk acoustic wave resonator, the at least two acoustic wave resonators included in the filter may be bulk acoustic wave resonators; alternatively, if the filter is a surface acoustic wave resonator, the at least two acoustic wave resonators included in the filter may be surface acoustic wave resonators.

The following describes, with reference to specific examples, how to adjust performance of a filter by adjusting a performance adjustment structure.

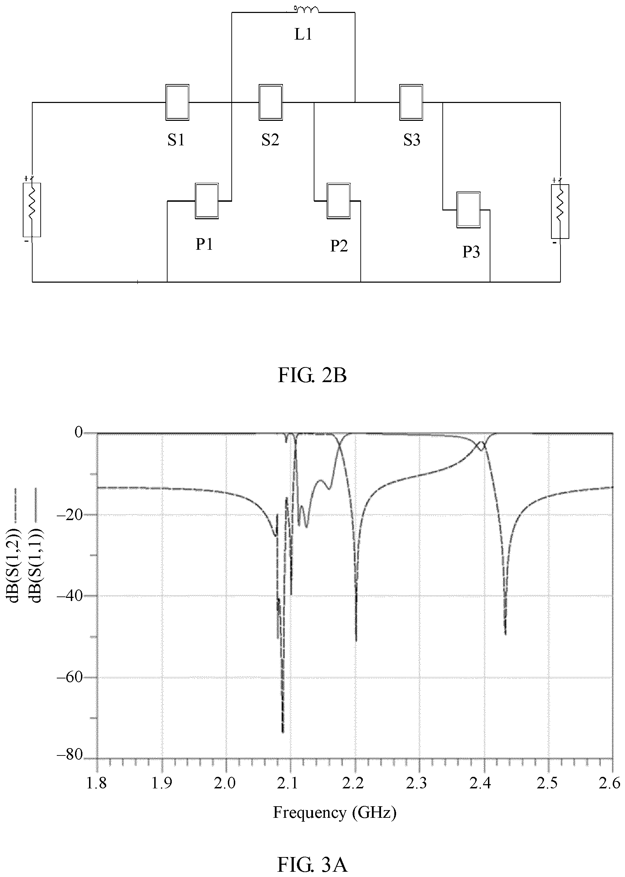

FIG. 2A is a topological structure diagram of a filter to which no performance adjustment structure is added. As shown in FIG. 2A, the filter includes six acoustic wave resonators: S1, S2, S3, P1, P2, and P3. FIG. 2B is a topological structure diagram of a filter to which a performance adjustment structure is added. As shown in FIG. 2B, a performance adjustment structure is an inductor L1 connected between an output end of S1 and an input end of S3. Therefore, a resonator size does not need to be changed and a connection relationship between other resonators does not need to be adjusted. Performance of the filter can be flexibly adjusted only by adjusting an inductance value of the inductor L1.

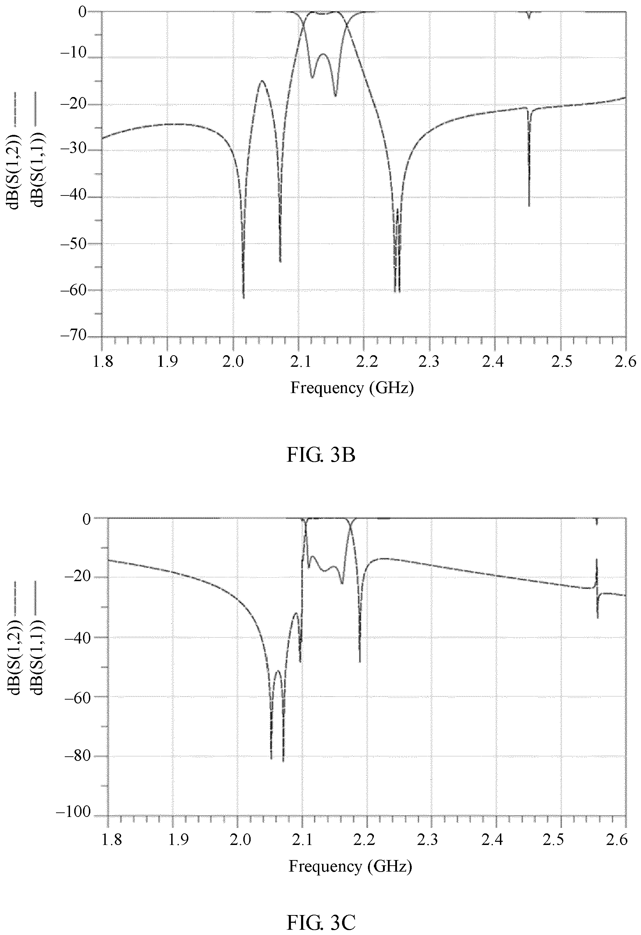

FIG. 3A, FIG. 3B, and FIG. 3C are schematic diagrams of passband performance of a filter corresponding to different L1 values. FIG. 3A is a simulation diagram of passband performance of the filter when L1=1 nh (nanohenry). FIG. 3B is a simulation diagram of passband performance of the filter when L1=3 nh. FIG. 3C is a simulation diagram of passband performance of the filter when L1=7 nh. It can be found through comparison of the foregoing three simulation diagrams that performance of the filter can be quickly adjusted only by adjusting an inductance value of L1. It should be understood that, inductance values in FIG. 3A to FIG. 3C are only used to describe an example effect, and a suitable inductance value needs to be selected in a specific application according to an actual case.

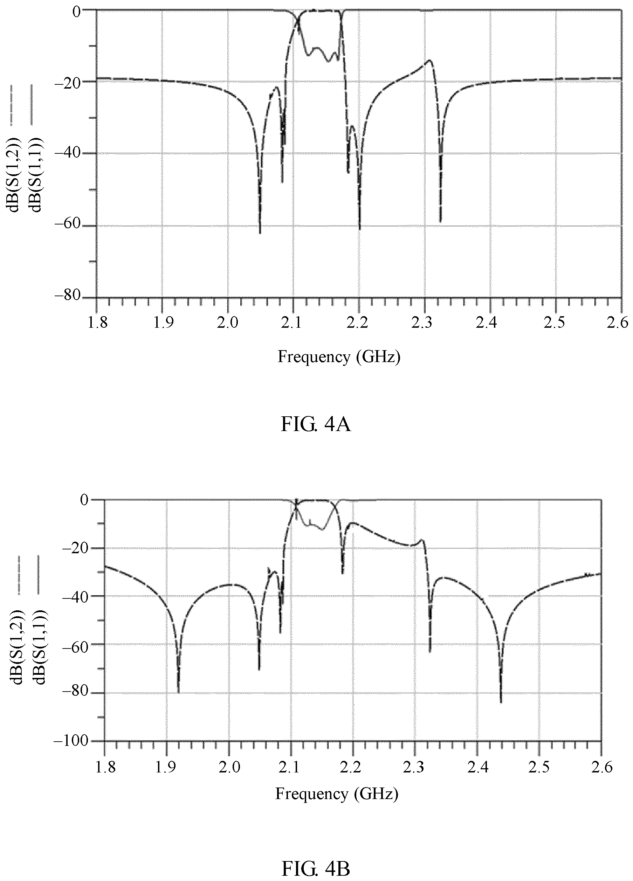

Another indicator for measuring performance of a filter is out-of-band rejection performance of the filter, and is represented as a bulge part of an out-of-band rejection curve in a simulation diagram. FIG. 4 is an out-of-band rejection curve of a topological structure shown in FIG. 2A, that is, an out-of-band rejection curve obtained when no performance adjustment structure is added. It can be seen from FIG. 4A that out-of-band rejection in an out-of-band low-frequency band 1.9 GHz to 2.0 GHz is only less than 20 dB. The inductor L1 is added between the resonator S1 and the resonator S3 in the topological structure shown in FIG. 2A, that is, a topological structure shown in FIG. 2B is used. In this way, the bulge part in the out-of-band rejection curve may be optimized by adjusting the inductor L1. FIG. 4B shows an out-of-band rejection curve obtained after an inductor L1 is added. It can be seen that out-of-band rejection performance in 1.9 GHz to 2.0 GHz is remarkably improved.

It should be understood that, for the topological structure shown in FIG. 2A, a performance adjustment structure may be an inductor L1. Optionally, the performance adjustment structure may further include more inductor devices. For example, more inductor devices may be added between S1 and S3. Alternatively, the performance adjustment structure may include only a capacitor device. For example, a capacitor device is added between S1 and S3, and there may be one or more capacitor devices. The performance adjustment structure may alternatively be a combined structure of a capacitor and an inductor, and one or more capacitors and inductors may be included. This is not limited in this embodiment of this application.

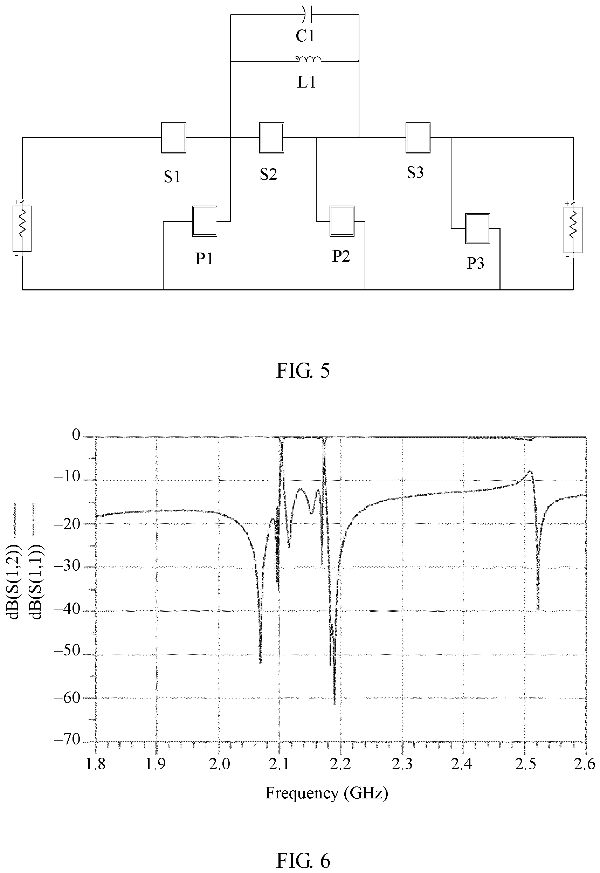

FIG. 5 is a topological structure diagram of a filter to which a combined structure of a capacitor and an inductor is added. As shown in FIG. 5, a performance adjustment structure is a combined structure of an inductor L1 and a capacitor C1. FIG. 6 shows an out-of-band rejection performance curve obtained after a combined structure of an inductor and a capacitor is added. It can be seen from FIG. 6 that out-of-band rejection performance in 2180 MHz to 2200 MHz is obviously improved.

It should be noted that, in a simulation diagram in this embodiment of this application, S(1,1) indicates a reflection coefficient curve of a filter and is indicated by using dB, and S(1,2) indicates a transmission coefficient curve of the filter and is indicated by using dB. Therefore, according to the filter in this embodiment of this application, the performance adjustment structure is connected between any two acoustic wave resonators of the filter, and the performance adjustment structure includes a capacitor structure and/or an inductor structure. In this way, performance of the filter can be quickly adjusted by adjusting a capacitance or inductance parameter value of the performance adjustment structure. Optionally, a quantity of acoustic wave resonators included in the filter and a series/parallel connection mode between resonators may be designed according to a specific requirement. This is not limited in this application.

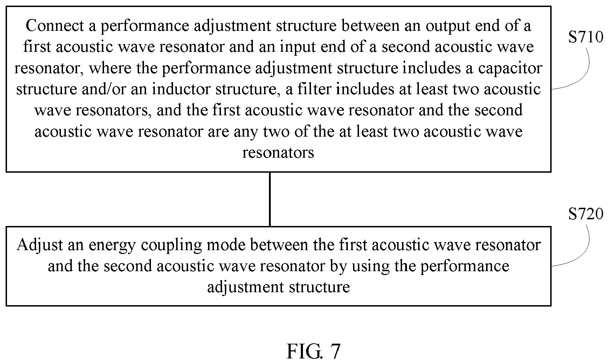

The foregoing describes the filter according to the embodiments of this application with reference to FIG. 1 to FIG. 6. With reference to FIG. 7, the following describes a method for adjusting performance of a filter according to an embodiment of this application.

FIG. 7 is a schematic flowchart of a method 700 for adjusting performance of a filter according to an embodiment of this application. As shown in FIG. 7, the method 700 includes the following steps.

S710. Connect a performance adjustment structure between an output end of a first acoustic wave resonator and an input end of a second acoustic wave resonator, where the performance adjustment structure includes a capacitor structure and/or an inductor structure, the filter includes at least two acoustic wave resonators, and the first acoustic wave resonator and the second acoustic wave resonator are any two of the at least two acoustic wave resonators. S720. Adjust an energy coupling mode between the first acoustic wave resonator and the second acoustic wave resonator by using the performance adjustment structure.

Specifically, the filter may include at least two acoustic wave resonators. The performance adjustment structure may be connected between any two of the at least two acoustic wave resonators. The performance adjustment structure includes a capacitor structure and/or an inductor structure, that is, the performance adjustment structure may be a capacitor structure, may be an inductor structure, or may be a combined structure of a capacitor and an inductor. That the performance adjustment structure is connected between the first acoustic wave resonator and the second acoustic wave resonator is equivalent to that an energy coupling mode between the two acoustic wave resonators is changed. Different energy coupling modes between resonators are corresponding to different filter characteristics. Therefore, a characteristic of the filter can be quickly adjusted by adjusting the performance adjustment structure. For example, when the performance adjustment structure includes an inductor structure, performance of the filter can be quickly adjusted by adjusting an inductance value. For another example, when the performance adjustment structure includes a capacitor structure, performance of the filter can be quickly adjusted by adjusting a capacitance value. In a specific implementation, the performance adjustment structure may be an inductor structure, where the inductor structure may be implemented in at least one of the following manners: a bonding wire, a metal via, an embedded metal wire, and a discrete inductor device. Optionally, the bonding wire may be a gold bonding wire, and the embedded metal wire may be a spiral embedded wire. Alternatively, the performance adjustment structure may be a capacitor structure, where the capacitor structure may be implemented in at least one of the following manners: a plate capacitor, a discrete capacitor device, and the like. Alternatively, the performance adjustment structure may be a combined structure of an inductor and a capacitor, where the inductor structure in the combined structure may be implemented through at least one of the foregoing implementations of the inductor structure, and the capacitor structure in the combined structure may be implemented through at least one of the foregoing implementations of the capacitor structure.

Optionally, the performance adjustment structure is connected between the output end of the first acoustic wave resonator 110 and the input end of the second acoustic wave resonator 120 through welding or embedding.

It should be understood that, in an actual application, it may be determined, based on a specific scenario, to add a performance adjustment structure of a specific structure; or it may be determined, based on an actual requirement, to add a performance adjustment structure between which two acoustic wave resonators; or a performance adjustment structure may be added between each two of at least two acoustic wave resonators. For example, a performance adjustment structure 1 is added between a first acoustic wave resonator and a second acoustic wave resonator, and a performance adjustment structure 2 may be added between a third acoustic wave resonator and a fourth acoustic wave resonator, where the performance adjustment structure 1 and the performance adjustment structure 2 may be the same or may be different in structure; and the performance adjustment structure 1 and the performance adjustment structure 2 may be adjusted according to an actual case.

Optionally, the first acoustic wave resonator and the second acoustic wave resonator may be adjacent resonators or may be non-adjacent resonators.

For the topological structure of the filter shown in FIG. 2A, the first acoustic wave resonator and the second acoustic wave resonator may be S1 and S2 or may be S1 and S3. In other words, the first acoustic wave resonator and the second acoustic wave resonator may be any two of the six resonators included in the filter.

Optionally, the filter may be a bulk acoustic wave filter or a surface acoustic wave filter. For example, the filter may be an FBAR filter, an SMR filter, or an SAW filter.

For the topological structure shown in FIG. 2A, the performance adjustment structure may be an inductor structure. One inductor may be included in the inductor structure, for example, a case in the topological structure shown in FIG. 2B; or a plurality of inductors may be included in the inductor structure. Alternatively, the performance adjustment structure may be a capacitor structure, and one or more capacitors may be included in the capacitor structure. Alternatively, the performance adjustment structure may be a combined structure of a capacitor and an inductor. Quantities of capacitors and inductors included in the combined structure are not limited, for example, a case in a topological structure shown in FIG. 5. Optionally, the performance adjustment structure is connected between the output end of the first acoustic wave resonator and the input end of the second acoustic wave resonator through welding or embedding.

For example, if the performance adjustment structure is a bonding wire, a discrete inductor device, or a discrete capacitor device, the performance adjustment structure may be connected between the output end of the first acoustic wave resonator and the input end of the second acoustic wave resonator through welding; or if the performance adjustment structure is a metal via or an embedded metal wire, the performance adjustment structure may be connected between the output end of the first acoustic wave resonator and the input end of the second acoustic wave resonator through embedding.

Therefore, according to the method for adjusting performance of a filter in this embodiment of this application, the performance adjustment structure is connected between any two acoustic wave resonators of the filter, and the performance adjustment structure includes a capacitor structure and/or an inductor structure. In this way, performance of the filter can be quickly adjusted by adjusting a capacitance or inductance parameter value of the performance adjustment structure.

It should be understood that, the filter in the embodiments of this application may be applied to various fields. For example, the filter may be applied to a network device in a wireless communications network. For example, the filter may be applied to a component of a base station, such as a duplexer, a power divider, an antenna, a feed network, a phase shifter, and an active circuit; or may be applied to a transmitter and a receiver in a terminal device, where the terminal device may be a cellular phone, a cordless telephone, a handheld device with a wireless communication function, or the like.

In an actual application, the filter or any of the foregoing devices in the embodiments of this application may implement a specific function by using a plurality of discrete devices, may implement a specific function in an integrated circuit form, or may be integrated into at least one chip to implement a specific function; or the like.

It should be understood that the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

It should be understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A filter, comprising:
at least two acoustic wave resonators; and
a performance adjustment structure, connected to an output end of a first acoustic wave resonator and an input end of a second acoustic wave resonator, wherein the first acoustic wave resonator and the second acoustic wave resonator are any two of the at least two acoustic wave resonators, and the performance adjustment structure comprises a capacitor structure and/or an inductor structure; wherein
the performance adjustment structure is configured to adjust an energy coupling mode between the first acoustic wave resonator and the second acoustic wave resonator.

2. The filter according to claim 1, wherein the first acoustic wave resonator and the second acoustic wave resonator are non-adjacent resonators.

3. The filter according to claim 1 or 2, wherein the performance adjustment structure is implemented in at least one of the following manners: a bonding wire, a metal via, an embedded metal wire, a discrete inductor device, or a discrete capacitor device.

4. The filter according to any one of claims 1 to 3, wherein the performance adjustment structure is connected between the output end of the first acoustic wave resonator and the input end of the second acoustic wave resonator through welding or embedding.

5. The filter according to any one of claims 1 to 4, wherein the acoustic wave resonator is a bulk acoustic wave resonator or a surface acoustic wave resonator.

6. A method for adjusting performance of a filter, comprising:
connecting a performance adjustment structure between an output end of a first acoustic wave resonator and an input end of a second acoustic wave resonator, wherein the performance adjustment structure comprises a capacitor structure and/or an inductor structure, the filter comprises at least two acoustic wave resonators, and the first acoustic wave resonator and the second acoustic wave resonator are any two of the at least two acoustic wave resonators; and
adjusting an energy coupling mode between the first acoustic wave resonator and the second acoustic wave resonator by using the performance adjustment structure.

7. The method according to claim 6, wherein the first acoustic wave resonator and the second acoustic wave resonator are non-adjacent resonators.

8. The method according to claim 6 or 7, wherein the performance adjustment structure is implemented in at least one of the following manners: a bonding wire, a metal via, an embedded metal wire, a discrete inductor device, or a discrete capacitor device.

9. The method according to any one of claims 6 to 8, wherein the connecting a performance adjustment structure between an output end of a first acoustic wave resonator and an input end of a second acoustic wave resonator comprises:
connecting the performance adjustment structure between the output end of the first acoustic wave resonator and the input end of the second acoustic wave resonator through welding or embedding.

10. The method according to any one of claims 6 to 9, wherein the acoustic wave resonator is a bulk acoustic wave resonator or a surface acoustic wave resonator.
